# EUROPÄISCHE PATENTANMELDUNG

(11) **EP 0 649 175 A1**
(43) Veröffentlichungstag der Anmeldung: **19.04.1995**
(21) Anmeldenummer: 94115202.7
(22) Anmeldetag: 27.09.1994
(51) Int. Cl.: H01L 29/72, H01L 27/088

(54) **Laterales IGBT-Bauteil mit schaltbarer Anodenstruktur**

(30) Priorität: 15.10.1993 DE 4335298
(71) Anmelder: SIEMENS AKTIENGESELLSCHAFT, D-80333 München (DE)
(72) Erfinder: Oppermann, Klaus-Günther, Dipl. Phys., D-83607 Holzkirchen (DE); Stoisiek, Michael Dr., D-85521 Ottobrunn (DE)

(57) **Zusammenfassung**

In einem bipolaren Leistungsbauelement, zum Beispiel einem IGBT, mit einer Emitterstruktur (12) zur Leitfähigkeitsmodulation und einem Driftbereich (10) vom entgegengesetzten Leitfähigkeitstyp sind die Emitterstruktur (12) mit einem ersten Kontakt (13) und der Driftbereich (10) mit einem zweiten Kontakt (15) versehen. Der erste Kontakt (13) und der zweite Kontakt (15) sind mit einer ansteuerbaren Widerstandsschaltung so verbunden, daß in Abhängigkeit eines Steuersignals an der Widerstandsschaltung (16) der Strom durch das Leistungsbauelement wahlweise über den ersten Kontakt (13) und/oder den zweiten Kontakt (15) zu einem dritten Kontakt (17) der Widerstandsschaltung fließt.

Auf diese Weise kann zum schnelleren Abschalten des Leistungbauelementes die Leitfähigkeitsmodulation ausgeschaltet werden.

## Beschreibung

Viele Leistungsbauelemente umfassen einen schwach dotierten Driftbereich, der die Hochspannungsfestigkeit des Leistungsbauelementes bestimmt. Um die Leitfähigkeit des schwach dotierten Driftbereichs im eingeschalteten Zustand des Leistungsbauelementes zu erhöhen, ist in dem Driftbereich vielfach eine Emitterstruktur vorgesehen. Driftbereich und Emitterstruktur bilden einen in Durchlaßrichtung gepolten pn-Übergang, der vom Hauptstrom durchflossen wird. Im eingeschalteten Zustand werden von diesem pn-Übergang Ladungsträger in den Driftbereich injiziert.

Ein spezielles Bauelement dieser Art ist der Insulated Gate Bipolar Transistor (IGBT), der zum Beispiel aus H. Dorwish et al, Electronics Letters, Vol. 20, No. 12, S. 519 bis 520 (1984) bekannt ist. Es handelt sich um einen Hochspannungs-DMOS-Transistor, bei dem der Hauptstrom einen in Durchlaßrichtung gepolten pn-Übergang durchfließt. Der pn-Übergang wird gebildet durch eine Emitterstruktur, die von einem vom entgegengesetzten Leitfähigkeitstyp schwach dotierten Driftbereich umgeben ist. IGBT's können vertikal oder lateral in einem Siliziumsubstrat realisiert sein. Laterale IGBT's werden im allgemeinen zur Integration in einer intergrierten Schaltung benutzt.

Die Leitfähigkeitsmodulation, das heißt die Erhöhung der Leitfähigkeit des Driftbereichs im eingeschalteten Zustand durch vom pn-Übergang injizierte Ladungsträger, verbessert zwar die Leitfähigkeit des IGBT im eingeschalteten Zustand, sie führt jedoch auch zu einer Reihe von Nachteilen im Vergleich zu einem äquivalenten DMOS-Transistor. Im Vergleich zu einem äquivalenten DMOS-Transistor zeigt ein IGBT eine reduzierte Sperrfähigkeit. Bedingt durch den pn-Übergang an der Emitterstruktur weist die Ausgangskennlinie eine Schwellspannung auf. Da der IGBT eine pnpn-Folge umfaßt, neigt er zum Latchen bei hohem Strom. Unter Latchen versteht man ein thyristorartiges Verhalten, bei dem der IGBT nicht mehr steuerbar ist. Wegen der Ladungsträgerinjektion im eingeschalteten Zustand kommt es beim IGBT zu schlechtem Abschaltverhalten bezüglich Schaltzeit und Schaltverlusten. Schließlich ist es nicht möglich, im IGBT eine Freilaufdiode zu integrieren.

Es sind verschiedene Maßnahmen vorgeschlagen worden (siehe zum Beispiel J. K. O. Sin, IEEE Transaction on Electron Devices, Vol. 40, S. 1300 bis 1305 (1993); A. R. Hefner et al, IEEE Transactions on Power Electronics, Vol. PE-2, S. 194 bis 206 (1987); G. Miller et al, IEEE, PESC 1989, Record Vol., I S. 21 bis 25), um die Eigenschaften eines IGBT zu verbessern. Das Abschaltverhalten wird zum Beispiel durch einen lokalen Nebenschluß an den durch Emitterstruktur und Driftbereich gebildeten pn-Übergang verbessert. Dazu wird parallel zu dem pn-Übergang ein Widerstandspfad geschaltet. Solange der Hauptstrom durch den IGBT unterhalb eines durch den Leitwert des Nebenschlusses bestimmten kritischen Wertes ist, fließt er durch den Nebenschluß. Dann findet keine Ladungsträgerinjektion aus der Emitterstruktur in den Driftbereich statt. Ist der Hauptstrom dagegen größer als dieser kritische Strom, so fließt er durch den pn-Übergang und die Emitterstruktur. In diesem Fall findet die Leitfähigkeitsmodulation des Driftbereichs statt. Die Durchlaßeigenschaften des IGBT verschlechtern sich jedoch durch den Nebenschluß.

Eine Reduktion der Emittereffizienz der Emitterstruktur kann im Fall eines n-dotierten Driftbereichs durch eine Erhöhung der Dotierstoffkonzentration vor dem durch Driftbereich und Emitterstruktur gebildeten pn-Übergang erzielt werden. Auch in diesem Fall verschlechtern sich die Durchlaßeigenschaften des IGBT.

Ferner ist bekannt, durch Verwendung eines extrem dünnen Kontaktes als Anode zur Emitterstruktur die Emittereffizienz zu reduzieren, was wiederum mit einer Verschlechterung der Durchlaßeigenschaften verbunden ist.

Schließlich ist vorgeschlagen worden, die Ladungsträgerlebensdauer im Driftbereich durch eine Dotierung mit Schwermetallen wie Au oder Pt oder durch Elektronenbestrahlung zu reduzieren. Dadurch werden jedoch die Durchlaßeigenschaften nachteilig beeinflußt. Außerdem kann dieses Verfahren im Rahmen einer IC-Technologie nicht eingesetzt werden, da es mit einer nachteiligen Wirkung auf andere integrierte Bauelemente verbunden ist.

Diese Problematik tritt nicht nur bei IGBT's sondern auch bei anderen bipolaren Leistungsbauelementen wie Bipolartransistoren oder Thyristoren auf.

Der Erfindung liegt das Problem zugrunde, eine Schaltungsstruktur mit einem bipolaren Leistungsbauelement anzugeben, die eine Emitterstruktur zur Leitfähigkeitsmodulation eines Driftbereichs aufweist und die im Vergleich zum Stand der Technik ein verbessertes Schaltverhalten zeigt.

Ferner liegt der Erfindung das Problem zugrunde ein Verfahren zum Betrieb eines bipolaren Leistungsbauelementes anzugeben, mit dem das Abschaltverhalten des bipolaren Leistungsbauelementes verbessert wird.

Dieses Problem wird erfindungsgemäß gelöst durch eine Schaltungsstruktur nach Anspruch 1 sowie ein Verfahren zum Betrieb eines bipolaren Leistungsbauelementes gemäß Anspruch 7. Weitere Ausgestaltungen der Erfindung gehen aus den Unteransprüchen hervor.

Gemäß der Erfindung werden die Emitterstrukturen mit einem ersten Kontakt und der Driftbereich mit einem zweiten Kontakt versehen.

Der erste Kontakt und der zweite Kontakt werden mit einer ansteuerbaren Widerstandsschaltung verbunden, die darüber hinaus einen dritten Kontakt aufweist. Die ansteuerbare Widerstandsschaltung ist so ausgelegt, daß in Abhängigkeit eines Steuersignals, das über eine Steuerelektrode an die ansteuerbare Widerstandsschaltung angelegt wird, der Hauptstrom durch das Leistungsbauelement wahlweise über den ersten Kontakt, über den zweiten Kontakt oder über den ersten Kontakt und den zweiten Kontakt zu dem dritten Kontakt fließt. Die Widerstandsschaltung weist eine Strom-Spannungskennlinie auf, deren Verlauf im Bereich des Nulldurchgangs im wesentlichen dem Verlauf der Strom-Spannungskennlinie eines ohmschen Widerstands entspricht.

Als Strom-Spannungskennlinie wird die Spannung als Funktion des Stroms bezeichnet. Liegt an der Widerstandsschaltung eine Spannung von 0 Volt an, fließt kein Strom. Das heißt, die Strom-Spannungskennlinie umfaßt den Wert (0 Ampere, 0 Volt). Im Bereich dieses Nulldurchgangs verläuft die Strom-Spannungskennlinie der Widerstandsschaltung im wesentlichen linear.

Es liegt im Rahmen der Erfindung, die ansteuerbare Widerstandsschaltung als Umschalter zu realisieren. In diesem Fall wird in Abhängigkeit eines Steuersignals wahlweise der erste Kontakt mit dem dritten Kontakt oder der zweite Kontakt mit dem dritten Kontakt verbunden. Alternativ kann die ansteuerbare Widerstandschaltung einen ansteuerbaren Schalter zwischen dem zweiten Kontakt und dem dritten Kontakt umfassen, während der erste Kontakt direkt mit dem dritten Kontakt verbunden ist. Bei geöffnetem Schalter fließt in diesem Fall der Hauptstrom durch das Leistungsbauelement über die Emitterstruktur, den ersten Kontakt und den dritten Kontakt. Zwischen dem ersten Kontakt und dem dritten Kontakt findet dabei im wesentlichen kein Spannungsabfall statt. Bei geschlossenem Schalter fließt der Hauptstrom in diesem Fall über den zweiten Kontakt zum dritten Kontakt.

Es liegt im Rahmen der Erfindung, anstelle von Schaltern, die ein- oder ausgeschaltet sind, Transistoren zu verwenden. Im Fall eines Umschalters ist sowohl zwischen dem ersten Kontakt und dem dritten Kontakt als auch zwischen dem zweiten Kontakt und dem dritten Kontakt ein Transistor verschaltet, der jeweils über ein Steuersignal angesteuert wird. Abhängig von der Höhe des Steuersignals kann die Leitfähigkeit des Transistors eingestellt werden. Auf diese Weise ist es möglich, die Leitfähigkeiten der beiden parallel geschalteten Transistoren so einzustellen, daß der Hauptstrom sich in einem vorgebbaren Verhältnis auf die beiden Zweige verteilt.

In dem anderen Beispiel wird nur zwischen den zweiten Kontakt und den dritten Kontakt ein Transistor geschaltet. Der erste Kontakt ist direkt mit dem dritten Kontakt verbunden. Auch in diesem Beispiel ist die Leitfähigkeit des Transistors durch die Höhe des Steuersignals ansteuerbar. Abhängig von der Leitfähigkeit des Transistors verteilt sich der Hauptstrom durch das Leistungsbauelement auf die beiden Zweige.

Es können in der ansteuerbaren Widerstandsschaltung sowohl Bipolar- als auch MOS-Transistoren verwendet werden.

In der erfindungsgemäßen Schaltungsstruktur fließt der Hauptstrom durch das bipolare Leistungsbauelement in Abhängigkeit eines Steuersignals über den pn-Übergang Driftbereich/Emitterstruktur zu dem ersten Kontakt oder durch den Driftbereich zu dem zweiten Kontakt. Durch Anlegen eines Steuersignals ist es in der erfindungsgemäßen Schaltungsstruktur daher möglich, die Leitfähigkeitsmodulation durch Injektion von Ladungsträgern über den pn-Übergang Emitterstruktur/Driftbereich ein- und auszuschalten. Beim Einschalten des Leistungsbauelementes ist es vorteilhaft, die ansteuerbare Widerstandsschaltung so anzusteuern, daß es zu einer Leitfähigkeitsmodulation im Driftbereich kommt. Beim Abschalten des Leistungsbauelementes ist es dagegen vorteilhaft, die Leitfähigkeitsmodulation dadurch abzuschalten, daß der Strom über den zweiten Kontakt geleitet wird. Für spezielle Anwendungen, zum Beispiel beim Abkommutieren eines in einer Freilaufdiode fließenden Stromes durch eine Induktivität in den eingeschalteten IGBT, ist es vorteilhaft, die Leitfähigkeitsmodulation nicht abrupt einzuschalten und den Hauptstrom durch das Leistungsbauelement zumindest zeitweise parallel über den ersten Kontakt und den zweiten Kontakt zu leiten.

Es ist besonders vorteilhaft, die Schaltungsstruktur in einem Substrat, das Silizium umfaßt, zu realisieren und in dem Substrat eine dielektrische Isolation vorzusehen, durch die das Leistungsbauelement gegen das Substrat und gegen die ansteuerbare Widerstandschaltung isoliert ist. In diesem Fall sind die Raumladungszonen im Leistungsbauelement keinerlei weiteren Einflüssen unterworfen und der Ladungsträgerabfluß bzw. die ladungsträgerinjektion ist allein von den elektrischen Feldern im Bauelement sowie den momentanen Widerstandswerten der ansteuerbaren Widerstandsschaltung abhängig. Dadurch lassen sich die Durchlaßeigenschaften sowie das Abschaltverhalten des Leistungsbauelementes kontrolliert steuern.

Es ist besonders vorteilhaft, die dielektrische Isolation durch eine durchgehende, isolierende Schicht, die unterhalb des Leistungsbauelementes und der ansteuerbaren Widerstandsschaltung im Substrat verläuft, sowie vertikal durch einen das Bauelement ringförmig vollständig umgebenden Graben, der mit isolierendem Material gefüllt ist, zu realisieren. Vorzugsweise ist auch die ansteuerbare Widerstandsschaltung von einem solchen isolierenden Graben vollständig ringförmig umgeben. Die dielektrische Isolation läßt sich auf diese Weise besonders einfach bei Verwendung eines SOI-Substrates realisieren. Das Leistungsbauelement und die Widerstandsschaltung sind dann in der einkristallinen Siliziumschicht des SOI-Substrats realisiert und jeweils von einem isolierenden Graben umgeben.

Die Schaltungsstruktur ist insbesondere vorteilhaft für einen IGBT einsetzbar. In diesem Fall umfaßt das Leistungsbauelement einen n⁺-dotierten Sourcebereich, der von einem p-dotierten Kanalbereich umgeben ist. Der Kanalbereich grenzt so an den n⁻-dotierten Driftbereich an, daß ein Strom zwischen dem Sourcebereich und der p⁺-dotierten Emitterstruktur den Driftbereich durchquert. Der IGBT umfaßt ferner eine Kathode, die an der Oberfläche des Sourcebereichs und des Kanalbereichs angeordnet ist und Source- und Kanalbereich kurzschließt. Der Kanalbereich ist ferner mit einem Gatedielektrikum versehen, an dessen Oberfläche eine Gateelektrode angeordnet ist. Der dritte Kontakt der ansteuerbaren Widerstandsschaltung bildet hierbei eine Anode des IGBT.

Umfaßt die Schaltungsstruktur als Leistungsbauelement einen IGBT und sind IGBT und ansteuerbare Widerstandsschaltung in einem Substrat mit dielektrischer Isolation realisiert, so bildet die Schaltungsstruktur nach außen ein einziges neuartiges Bauelement mit einer Kathode, einer Anode, einer Gateelektrode für den IGBT und mindestens einer Steuerelektrode für die ansteuerbare Widerstandsschaltung.

Es liegt im Rahmen der Erfindung, in der ansteuerbaren Widerstandsschaltung MOS-Transistoren vorzusehen, deren Kanalbereich an der Oberfläche des Substrats zickzackförmig, gefaltet oder mäanderförmig verläuft.

Im folgenden wird die Erfindung anhand der Ausführungsbeispiele und der Figuren näher erläutert.
- Figur 1: zeigt einen IGBT mit einem elektronischen Umschalter.
- Figur 2: zeigt einen IGBT mit ansteuerbarer Widerstandsschaltung, die einen MOS-Transistor mit gefaltetem Kanalbereich umfaßt.
- Figur 3: zeigt den in Figur 2 mit III-III bezeichneten Schnitt durch den IGBT.
- Figur 4: zeigt den in Figur 2 mit IV-IV bezeichneten Schnitt durch die ansteuerbare Widerstandsschaltung.
- Figur 5: zeigt eine Aufsicht auf einen IGBT mit einer ansteuerbaren Widerstandsschaltung, die zwei MOS-Transistoren mit gefaltetem Kanalbereich umfaßt.
- Figur 6: zeigt eine Aufsicht auf einen IGBT mit ansteuerbarer Widerstandsschaltung, in dem eine Leiterbahn für einen n⁺-Kontakt und eine Leiterbahn für einen p⁺-Kontakt vorgesehen sind.

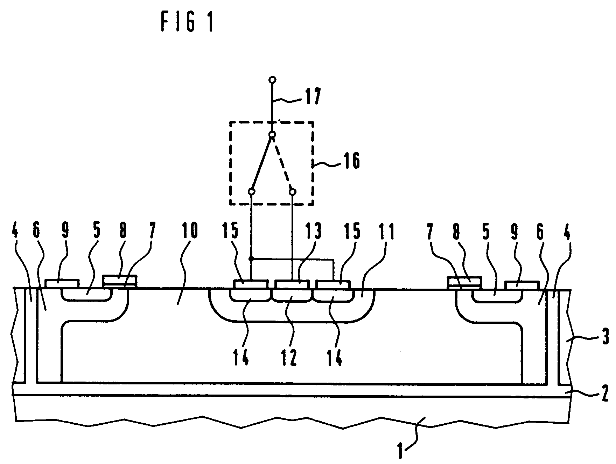

Auf einer einkristallinen Siliziumscheibe 1 ist eine isolierende Schicht 2 und darauf eine einkristalline Siliziumschicht 3 angeordnet (siehe Figur 1). Die Siliziumscheibe 1, die isolierende Schicht 2 und die einkristalline Siliziumschicht 3 sind zum Beispiel Bestandteile eines SOI-Substrats, das vorzugsweise nach dem Direct wafer bonding-(DWB)-Verfahren hergestellt ist.

In der einkristallinen Siliziumschicht 3 ist ein Isolationsgraben 4 angeordnet, der bis auf die isolierende Schicht 2 reicht. Der Isolationsgraben 4 umgibt ein Gebiet für einen IGBT ringförmig und ist mit isolierendem Material gefüllt.

Innerhalb des von der isolierenden Schicht 2 und dem Isolationsgraben 4 umgebenen Gebietes ist ein IGBT realisiert. Er umfaßt ein n⁺-dotiertes Sourcegebiet 5, das von einem ringförmigen p-dotierten Gebiet 6 umgeben ist. Das p-dotierte Gebiet 6 umfaßt einen Kanalbereich für den IGBT. An der Oberfläche des Kanalbereichs des p-dotierten Gebietes 6 ist ein Gatedielektrikum 7 und darauf eine Gateelektrode 8 angeordnet.

An der Oberfläche des Sourcegebietes 5 ist eine Sourceelektrode 9 angeordnet, die auch mit dem p-dotierten Gebiet 6 an der dem Kanalbereich abgewandten Seite in Kontakt steht. Die Sourceelektrode 9, die im Betrieb des IGBT als Kathode verschaltet wird, schließt das Sourcegebiet 5 mit dem p-dotierten Gebiet 6 kurz.

Das n⁺-dotierte Sourcegebiet 5 weist eine Dotierstoffkonzentration von zum Beispiel 10¹⁹ cm⁻³ auf. Das p-dotierte Gebiet 6 weist eine Dotierstoffkonzentration von zum Beispiel 2.10¹⁷ cm⁻³ auf.

Das p-dotierte Gebiet 6 grenzt an einen Driftbereich 10 an, der n⁻-dotiert ist und eine Dotierstoffkonzentration von zum Beispiel 6.10¹⁴ cm⁻³ aufweist. In der Mitte des Driftbereichs 10 ist eine n-dotierte Insel 11 mit einer Dotierstoffkonzentration von zum Beispiel 10¹⁷ cm⁻³ angeordnet. In der n-dotierten Insel 11 ist eine Emitterstruktur 12 angeordnet, die p⁺-dotiert ist. Die Emitterstruktur 12 weist eine Dotierstoffkonzentration von zum Beispiel 10¹⁹ cm⁻³ auf. An der Oberfläche der Emitterstruktur 12 ist ein erster Kontakt 13 angeordnet.

Es ist ein n⁺-dotiertes Anschlußgebiet 14 der Emitterstruktur 12 benachbart angeordnet. Das n⁺-dotierte Anschlußgebiet 13 ist vollständig in der n-dotierten Insel 11 angeordnet und umgibt die Emitterstruktur 12 zum Beispiel ringförmig. An der Oberfläche des n⁺-dotierten Anschlußgebietes 14 ist ein zweiter Kontakt 15 angeordnet. Der erste Kontakt 13 und der zweite Kontakt 15 sind mit einer ansteuerbaren Widerstandsschaltung 16 verbunden. Die ansteuerbare Widerstandsschaltung 16 weist einen dritten Kontakt 17 auf, der im Betrieb des IGBT als Anode verschaltet wird.

Die ansteuerbare Widerstandsschaltung 16 ist zum Beispiel als Umschalter ausgebildet, in dem in Abhängigkeit eines Steuersignals der erste Kontakt 13 und der dritte Kontakt 17 oder der zweite Kontakt 15 und der dritte Kontakt 17 verbunden werden.

In Anwendungen, in denen ein zusätzlicher Serienwiderstand zwischen der Emitterstruktur 12 und der Anode 17 vermieden werden soll, ist es vorteilhaft, die ansteuerbare Widerstandsschaltung 16 so auszulegen, daß der erste Kontakt 13 fest mit dem dritten Kontakt 17 verbunden ist und der zweite Kontakt 15 über einen ansteuerbaren Schalter mit dem dritten Kontakt 17 verbunden ist. Bei geöffnetem Schalter fließt dann der Strom durch die Emitterstruktur über den ersten Kontakt 13. Bei geschlossenem Schalter fließt der Strom wegen des pn-Übergangs an der Grenzfläche zwischen Emitterstruktur 12 und n-dotierter Insel 11 über das n⁺-dotierte Anschlußgebiet 14 und den zweiten Kontakt 15.

Zum Einschalten des IGBT und während des eingeschalteten Zustandes wird der erste Kontakt 13 mit dem dritten Kontakt 17 verbunden, während die Verbindung zwischen dem zweiten Kontakt 15 und dem dritten Kontakt 17 unterbrochen ist. Dadurch wird durch Injektion von Ladungsträgern am pn-Übergang zwischen Emitterstruktur 12 und n-dotierter Insel 11 maximale Leitfähigkeitsmodulation mit schnellstmöglichem Einschalten und niedrigstmöglichem Einschaltspannungsabfall (R_{On}) erzielt.

Zum Ausschalten des IGBT wird die Verbindung zwischen dem dritten Kontakt 17 und dem ersten Kontakt 13 unterbrochen und die Verbindung zwischen dem dritten Kontakt 17 und dem zweiten Kontakt 15 hergestellt. Dadurch wird die Ladungsträgerinjektion aus der Emitterstruktur 12 schlagartig unterbrochen. Die in den Driftbereich 10 während des eingeschalteten Zustandes injizierte Ladung wird durch Abfluß über das n⁺-dotierte Anschlußgebiet 14 und den zweiten Kontakt 15 schnellstmöglich abgebaut.

Im ausgeschalteten Zustand des IGBT bleibt der zweite Kontakt 15 mit dem dritten Kontakt 17 verbunden, um maximale Sperrfähigkeit zu erreichen. In dieser Anordnung bestimmt die aus dem p-dotierten Gebiet 6 und dem n-dotierten Driftbereich 10 gebildete Diode das Sperrverhalten. Die p⁺-dotierte Emitterstruktur 12 hat in diesem Betriebszustand keinen Einfluß auf die Sperrfähigkeit des IGBT.

Solange der erste Kontakt 13 mit dem dritten Kontakt 17 verbunden ist werden die speziellen IGBT-Vorteile der Struktur genutzt. Ist der dritte Kontakt 17 mit dem zweiten Kontakt 15 verbunden, so wird die erfindungsgemäße Schaltungsstruktur in einem "MOS-FET"-Modus betrieben und weist die Eigenschaften eines DMOS-Transistors auf.

Durch Anlegen eines entsprechenden Steuersignals wird die Schaltungsstruktur wahlweise im IGBT-Modus oder im MOS-FET-Modus betrieben, je nachdem, welche Eigenschaften für die Schaltung erforderlich sind.

In der erfindungsgemäßen Schaltungsstruktur kann es zwar bei Überschreiten eines maximalen Anodenstroms zum Latchen des IGBT kommen, durch Trennung der Verbindung zwischen dem dritten Kontakt 17 und dem ersten Kontakt 13 und durch Verbinden des dritten Kontaktes 17 mit dem zweiten Kontakt 15 läßt sich der dabei gezündete Thyristor jedoch kontrolliert abschalten.

Die zusätzliche ansteuerbare Widerstandsschaltung 16 wird in der erfindungsgemäßen Schaltungsstruktur vorzugsweise integriert außerhalb des Isolationsgrabens 4 realisiert. Die dielektrische Isolation des IGBT stellt sicher, daß der Ladungsabfluß bzw. die Ladungsträgerinjektion kontrolliert über den ersten Kontakt 13 bzw. den zweiten Kontakt 15 erfolgt.

Im Vergleich zu dem Standard-IGBT ohne ansteuerbare Widerstandsschaltung benötigt die erfindungsgemäße Schaltungsstruktur eine größere Fläche. Dieser erhöhte Flächenbedarf wird jedoch zum Teil dadurch kompensiert, daß aufgrund der besseren Durchlaßeigenschaften der IGBT in der erfindungsgemäßen Schaltungsstruktur eine höhere Stromtragfähigkeit aufweist. Das n⁺-dotierte Anschlußgebiet 14 kann darüber hinaus so dimensioniert werden, daß die p-dotiertes Gebiet 6/Driftbereich 10-Diode als Freilaufdiode benutzt werden kann. Dann fällt der Flächenbedarf für eine in vielen Schaltungen zusätzlich benötigte hochsperrende Freilaufdiode weg. Durch Entwurf einer ansteuerbaren Widerstandsschaltung mit einem Flächenbedarf, der kleiner ist als der einer Freilaufdiode, kann die erfindungsgemäße Schaltungsstruktur mit einem geringeren Flächenbedarf als eine konventionelle IGBT-Anordnung realisiert werden.

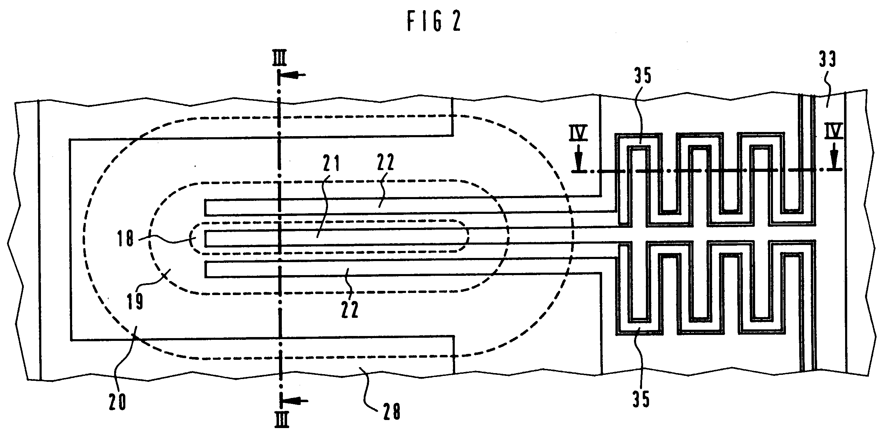

In Figur 2 ist eine Aufsicht auf eine erfindungsgemäße Schaltungsstruktur dargestellt. Durch gestrichelte Linien sind die Lage einer p⁺-dotierten Emitterstruktur 18, eines n⁺-dotierten Anschlußgebietes 19 sowie eines n⁻-dotierten Driftbereichs 20 angegeben. Die Emitterstruktur 18 weist eine Dotierstoffkonzentration von zum Beispiel 10¹⁹ cm⁻³, das Anschlußgebiet 19 von zum Beispiel 10¹⁹ cm⁻³ und der Driftbereich 20 von zum Beispiel 6.10¹⁴ cm⁻³ auf.

Die Emitterstruktur 18 ist mit einem ersten Kontakt 21 verbunden, der oberhalb der Emitterstruktur 18 verläuft. Das n⁺-dotierte Anschlußgebiet 19, das die Emitterstruktur 18 an der Oberfläche ringförmig umgibt, ist mit zwei zweiten Kontakten 22 versehen. Die zweiten Kontakte 22 verlaufen parallel zum ersten Kontakt 21 oberhalb des n⁺-dotierten Anschlußgebietes.

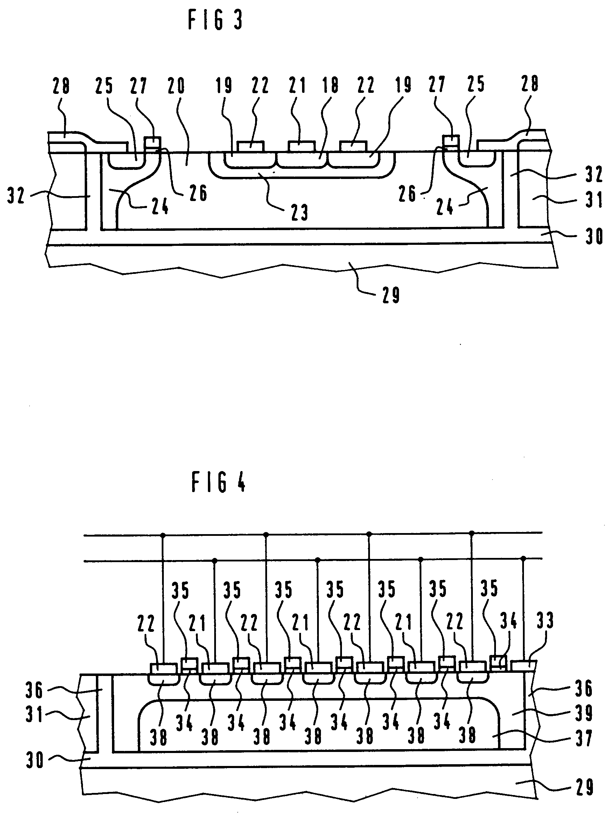

In Figur 3 ist der in Figur 2 mit III-III bezeichnete Schnitt durch die erfindungsgemäße Schaltungsstruktur dargestellt. Die Emitterstruktur 18 und das Anschlußgebiet 19 sind in einer n-dotierten Insel 23 angeordnet, die im Driftbereich 20 angeordnet ist. Der Driftbereich 20 grenzt an ein p-dotiertes Gebiet 24 an, das einen Kanalbereich des IGBT umfaßt. Das p-dotierte Gebiet 24 weist eine Dotierstoffkonzentration von zum Beispiel 2.10¹⁷ cm⁻³ auf. In dem p-dotierten Gebiet 24 ist ein n⁺-dotiertes, ringförmiges Sourcegebiet 25 angeordnet. An der Oberfläche des Kanalbereichs ist ein Gatedielektrikum 26 und darauf eine Gateelektrode 27 angeordnet. Die Gateelektrode 27 ist der Übersichtlichkeit halber in der Aufsicht in Figur 2 nicht eingezeichnet. Auf der dem Kanalbereich abgewandten Seite des Sourcegebietes 25 sind das Sourcegebiet 25 und das p-dotierte Gebiet 24 über eine an der Oberfläche angeordnete Kathode 28 miteinander verbunden.

Der IGBT ist in einem SOI-Substrat realisiert, das eine einkristalline Siliziumscheibe 29, eine darauf angeordnete isolierende Schicht 30 und eine darauf angeordnete einkristalline Siliziumschicht 31 umfaßt. In der Siliziumschicht 31 ist der IGBT realisiert. Er ist vollständig von einem Isolationsgraben 32 umgeben, der bis auf die Oberfläche der isolierenden Schicht reicht und der mit isolierendem Material gefüllt ist.

Außerhalb des Isolationsgrabens 32 ist in der Siliziumschicht 31 eine ansteuerbare Widerstandsschaltung realisiert (siehe Figur 2 und den mit IV-IV bezeichneten Schnitt in Figur 4). Die ansteuerbare Widerstandsschaltung ist als MOS-Transistorpaar zum Beispiel vom n-Kanal-Typ realisiert, wobei das Draingebiet mit dem ersten Kontakt 21 und einem dritten Kontakt 33, der im Betrieb der Schaltungsstruktur als Anode verschaltet wird, verbunden ist und das Sourcegebiet jeweils mit einem der zweiten Kontakte 22 verbunden ist. Source- und Draingebiet jedes MOS-Transistors umfassen dabei jeweils ein kammförmiges Gebiet, in dem parallel zueinander angeordnete Stege an ein senkrecht dazu verlaufendes Verbindungsteil angrenzen. Die mit dem ersten Kontakt 21 bzw. dem zweiten Kontakt 22 verbundene Metallisierung von Source- bzw. Draingebiet zeigt ebenfalls diese kammförmige Struktur. Die kammförmigen Gebiete von Source- und Draingebiet sind so zueinander angeordnet, daß die Stege von Source- und Draingebiet jeweils ineinander greifen und daß die Stege des Sourcegebietes und die Stege des Draingebietes jeweils abwechselnd angeordnet sind, so daß der Kanalbereich des MOS-Transistors um die Stege herum gefaltet verläuft. Oberhalb des Kanalbereichs ist ein Gatedielektrikum 34 und eine Gateelektrode 35 angeordnet. Die Gateelektrode 35 folgt dem gefalteten Verlauf des Kanalsbereichs (siehe Figur 2).

Das MOS-Transistorpaar ist vorzugsweise ringförmig von einem Isolationsgraben 36 umgeben (siehe Figur 4). Der Isolationsgraben 36 reicht bis auf die Oberfläche der isolierenden Schicht 30 und ist mit isolierendem Material gefüllt. Innerhalb des Isolationsgrabens 36 ist an der Grenzfläche zur isolierenden Schicht 30 ein n⁻ -dotiertes Gebiet angeordnet. Die n⁺-dotierten Source/Draingebiete 38 sind von einem p-dotierten Wannenbereich 39 umgeben.

Solange in diesem Ausführungsbeispiel das MOS-Transistorpaar sperrt, fließt der Hauptstrom durch den IGBT über den pn-Übergang der Emitterstruktur 18, den ersten Kontakt 21 und den dritten Kontakt 33. Wird das MOS-Transistorpaar über die Gateelektroden 34 dagegen so angesteuert, daß es leitet, und der Spannungsabfall über den MOS-Transistor jeweils geringer ist als die Schwellspannung des pn-Übergangs der Emitterstruktur 18, so fließt der Hauptstrom durch den IGBT über den zweiten Kontakt 22 in den MOS-Transistor zum dritten Kontakt 33. Über die Höhe des Steuersignals an der Gateelektrode 35 wird der Widerstand des MOS-Transistors im leitenden Zustand und damit der Spannungsabfall über den MOS-Transistor eingestellt. Durch das Steuersignal an der Gateelektrode kann der Hauptstrom gezielt verteilt über den ersten Kontakt 21 und den zweiten Kontakt 22 zum dritten Kontakt 33 fließen. Dieses ist zum Beispiel für eine Halbbrückenschaltung mit einem erfindungsgemäßen IGBT jeweils im oberen und unteren Brückenteil vorteilhaft. Dabei ist der untere IGBT mit seiner Kathode an Masse, der obere IGBT mit seiner Anode an positive Versorgungsspannung angeschlossen. Zwischen Halbbrückenmittelpunkt und Versorgungsspannung befindet sich eine Lastkreisinduktivität.

Beide IGBT's sind in den MOS-Fet bzw. Diodenmodus geschaltet. Der Strom aus der Induktivität fließt in Rückwärtsrichtung in den oberen IGBT, der als Freilaufdiode wirkt. Wenn der untere IGBT schneller eingeschaltet wird, als die Speicherladung aus dem oberen IGBT abgeflossen ist, fließt ein nahezu unbegrenzter Strom über die beiden IGBT's und führt in der Regel zur Zerstörung mindestens eines der beiden Bauelemente. Um dies zu verhindern, kann man zunächst den unteren IGBT im MOS-Fet-Modus einschalten und erst, nachdem die Speicherladung aus dem oberen IGBT abgeflossen ist, in den IGBT-Modus umschalten.

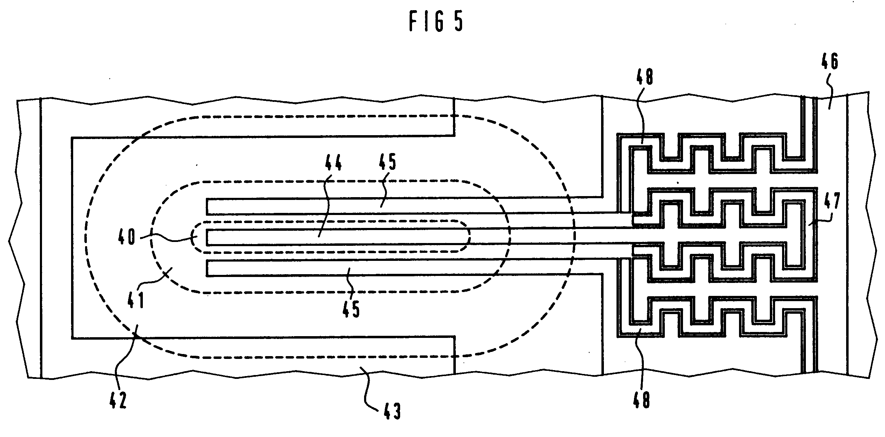

In Figur 5 ist ein weiteres Ausführungsbeispiel für eine erfindungsgemäße Schaltungsstruktur dargestellt. Sie umfaßt einen IGBT mit einer p⁺-dotierten Emitterstruktur 40, einem diese umgebenden n⁺-dotierten Anschlußgebiet 41 sowie einem n⁻-dotierten Driftbereich 42. Die Emitterstruktur 40, das Anschlußgebiet 41 und der Driftbereich 42 sind in Figur 5 als gestrichelte Linie dargestellt. Der Driftbereich 42 grenzt an ein p-dotiertes Gebiet an, das den "Body" des IGBT bildet und das einen Kanalbereich für den IGBT umfaßt. In das p-dotierte Gebiet ist ein n⁺-dotiertes Sourcegebiet eingebettet. Im Bereich des Kanalbereichs ist ein Gatedielektrikum und darauf eine Gateelektrode vorgesehen. P-dotiertes Gebiet, Sourcegebiet, Gatedielektrikum und Gatelektrode sind in Figur 5 der Übersichtlichkeit halber nicht eingezeichnet. Das Sourcegebiet und das p-dotierte Gebiet werden über eine Kathode 43 kontaktiert.

Die Emitterstruktur 40 ist über einen ersten Kontakt mit einer ersten Leiterbahn 44 verbunden. Das n⁺-dotierte Anschlußgebiet 41 ist über zweite Kontakte jeweils mit einer zweiten Leiterbahn 45 verbunden. Der IGBT ist in der einkristallinen Siliziumschicht eines SOI-Substrats realisiert und ist vollständig von einem Isolationsgraben umgeben, der bis auf die Oberfläche der isolierenden Schicht des SOI-Substrats reicht. Außerhalb des den IGBT umgebenden Isolationsgrabens ist eine ansteuerbare Widerstandsschaltung in der Siliziumschicht realisiert, die ebenfalls vollständig von einem Isolationsgraben umgeben ist. Die ansteuerbare Widerstandsschaltung ist über einen dritten Kontakt mit einer dritten Leiterbahn 46 verbunden, die im Betrieb der Schaltungsstruktur als Anode verschaltet wird.

Die ansteuerbare Widerstandsschaltung umfaßt einen ersten MOS-Transistor, der zwischen die erste Leiterbahn 44 und die dritte Leiterbahn 46 verschaltet ist. Ferner umfaßt die ansteuerbare Widerstandsschaltung zweite MOS-Transistoren, die jeweils zwischen die zweiten Leiterbahnen 45 und die dritte Leiterbahn 46 verschaltet sind. Alle MOS-Transistoren umfassen kammförmige Source/Draingebiete, in denen parallel zueinander angeordnete Stege an ein senkrecht dazu verlaufendes Verbindungsteil angrenzen. Kammförmige Gebiete eines MOS-Transistors sind so angeordnet, daß die Stege von Source- und Draingebiet jeweils ineinander greifen und daß die Stege des Sourcegebietes und die Stege des Draingebietes jeweils abwechselnd angeordnet sind, so daß der Kanalbereich des zugehörigen MOS-Transistors um die Stege herum gefaltet verläuft. Oberhalb des Kanalbereichs des ersten MOS-Transistors ist eine erste Gateelektrode 47 angeordnet, die dem gefalteten Verlauf des Kanalsbereichs folgt. Oberhalb der Kanalbereiche der zweiten MOS-Transistoren ist jeweils eine zweite Gateelektrode 48 angeordnet, die ebenfalls dem Verlauf der gefalteten Kanalbereiche folgt.

Durch entsprechendes Ansteuern der ersten Gateelektrode 47 und/oder der zweiten Gateelektrode 48 werden in diesem Ausführungsbeispiel die erste Leiterbahn 44 mit der dritten Leiterbahn 46 oder die zweiten Leiterbahnen 45 mit der dritten Leiterbahn 46 verbunden. In dieser Ausführungsform fließt der Strom durch den IGBT sowohl zwischen dem ersten Kontakt und dem dritten Kontakt als auch zwischen dem zweiten Kontakt und dem dritten Kontakt jeweils über einen leitenden MOS-Transistor.

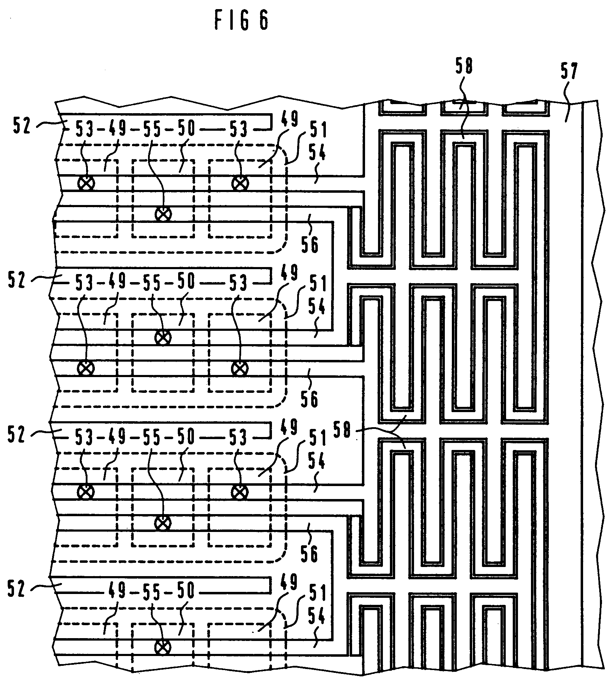

Anhand von Figur 6 wird im folgenden ein Ausführungsbeispiel erläutert, in dem im Bereich des IGBT nur zwei Leiterbahnen zur Kontaktierung von n⁺-dotiertem bzw. p⁺-dotiertem Gebiet erforderlich sind.

Wie in den anhand von Figur 2 und Figur 5 geschilderten Ausführungsbeispielen ist der IGBT in einer einkristallinen Siliziumschicht eines SOI-Substrates realisiert. Der IGBT ist dabei vollständig von einem Isolationsgraben umgeben, der bis auf die Oberfläche der isolierenden Schicht des SOI-Substrates reicht. Die ansteuerbare Widerstandsschaltung ist ebenfalls in der einkristallinen Siliziumschicht des SOI-Substrates realisiert und von einem weiteren Isolationsgraben, der bis auf die isolierende Schicht reicht, umgeben.

Der IGBT umfaßt p⁺-dotierte Emitterstrukturen 49, die abwechselnd benachbart mit n⁺-dotierten Anschlußgebieten 50 angeordnet sind. Die Anzahl der einander benachbart angeordneten Emitterstrukturen 49 und Anschlußgebiete 50 richtet sich nach der für die Anwendung der Schaltungsstruktur erforderlichen Stromtragfähigkeit des IGBT. Die Emitterstrukturen 49 und die n⁺-dotierten Anschlußgebiete 50 sind umgeben von n⁻-dotierten Driftbereichen 51. Im übrigen ist der IGBT nach demselben Prinzip aufgebaut wie anhand von Figur 2 und Figur 5 geschildert. Sourcegebiet und Body werden über eine Kathode 52 kurzgeschlossen. In Figur 6 sind nur Teile der Kathode 52 sichtbar, die außerhalb des Ausschnittes mit einer Kathodenschiene verbunden sind.

Die Emitterstrukturen 49 sind über einen ersten Kontakt 53 mit einer ersten Leiterbahn 54 verbunden. Die n⁺-dotierten Anschlußgebiete 50 sind über zweite Kontakte 55 mit einer zweiten Leiterbahn 56 verbunden.

Die erste Leiterbahn ist direkt mit einer dritten Leiterbahn 57 verbunden, die im Betrieb der Schaltungsstruktur als Anode verschaltet wird. Die ansteuerbare Widerstandsschaltung umfaßt eine MOS-Transistorstruktur, die zwischen die erste Leiterbahn 54 und die zweite Leiterbahn 56 geschaltet ist. Wie in dem anhand von Figur 2 geschilderten Ausführungsbeispiel sind die Source/Draingebiete der MOS-Transistorstruktur kammförmig ausgebildet und jeweils so zueinander angeordnet, daß die Stege von Source- und Draingebiet ineinander greifen und jeweils abwechselnd angeordnet sind. Der Kanalbereich des MOS-Transistors verläuft um die Stege herum gefaltet. Oberhalb der gefaltet verlaufenden Kanalbereiche sind Gateelektroden 58 angeordnet, die dem gefalteten Verlauf der Kanalbereiche folgen und die außerhalb der Ebene der Aufsicht miteinander verbunden sind. Durch entsprechende Ansteuerung der Gateelektrode 58 wird die MOS-Transistorstruktur leitend, so daß der Hauptstrom durch den IGBT über die zweiten Kontakte 55 und die zweite Leiterbahn 56 zur dritten Leiterbahn 57 fließt. Der p⁺n-Übergang an den Emitterstrukturen 49 bewirkt, daß der Hauptstrom nicht über die ersten Kontakte 53 und die erste Leiterbahn 54 zur dritten Leiterbahn 57 fließt, solange der Spannungsabfall über die MOS-Transistorstruktur kleiner als 0,5 Volt ist. Solange die MOS-Transistorstruktur sperrt fließt jedoch der Hauptstrom in den IBGT über die ersten Kontakte 53 und die ersten Leiterbahnen 54 zur dritten Leiterbahn 57.

Jeweils zwei benachbarte zeilenförmig angeordnete Emitterstruktur 49/Anschlußgebiet 50 Folgen bilden in dieser Schaltungsstruktur eine periodisch wiederholbare Grundeinheit. Wieviele solche Grundeinheiten aneinandergereiht werden, hängt von den Anforderungen der Anwendung der Schaltungsstruktur ab.

In dem anhand von Figur 2, 5 und 6 geschilderten Ausführungsbeispiel umfaßt die ansteuerbare Widerstandsschaltung jeweils mindestens einen MOS-Transistor. Die Gateelektrode dieser MOS-Transistoren sind jeweils in den Figuren in derselben Ebene wie die Leiterbahnen dargestellt worden. Bei der Realisierung der erfindungsgemäßen Schaltungsstruktur können die Gateelektroden in anderen Ebenen als die Leiterbahnen angeordnet sein, insbesondere können die Gateelektroden als vergrabene Gateelektroden realisiert sein. Insbesondere kann das Zusammenführen der verschiedenen Sourceelektroden bzw. Drainelektroden der MOS-Transistoren in der ansteuerbaren Widerstandsschaltung auch über verschiedene Metallisierungsebenen erfolgen.

### Bezugszeichenliste

- 1: Siliziumscheibe
- 2: isolierende Schicht
- 3: einkristalline Siliziumschicht
- 4: Isolationsgraben
- 5: Sourcegebiet
- 6: p-dotiertes Gebiet
- 7: Gatedielektrikum
- 8: Gatelektrode
- 9: Sourceelektrode
- 10: Driftbereich
- 11: n-dotierte Insel
- 12: Emitterstruktur
- 13: erster Kontakt
- 14: n⁺-dotiertes Anschlußgebiet
- 15: zweiter Kontakt
- 16: ansteuerbare Widerstandsschaltung
- 17: dritter Kontakt
- 18: p⁺-dotierte Emitterstruktur
- 19: n⁺-dotiertes Anschlußgebiet
- 20: n⁻-dotierter Driftbereich
- 21: erster Kontakt
- 22: zweiter Kontakt
- 23: n-dotierte Insel
- 24: p-dotiertes Gebiet
- 25: Sourcegebiet
- 26: Gatedielektrikum
- 27: Gateelektrode
- 28: Kathode
- 29: Siliziumscheibe
- 30: isolierende Schicht
- 31: Siliziumschicht
- 32: Isolationsgraben
- 33: dritter Kontakt
- 34: Gatedielektrikum
- 35: Gateelektrode
- 36: Isolationsgraben
- 37: n⁻-dotiertes Gebiet
- 38: n⁺-dotiertes Source/Draingebiet
- 39: p-dotiertes Wannengebiet
- 40: Emitterstruktur
- 41: Anschlußgebiet
- 42: Driftbereich
- 43: Kathode
- 44: erste Leiterbahn
- 45: zweite Leiterbahn
- 46: dritte Leiterbahn
- 47: erste Gateelektrode
- 48: zweite Gateelektrode
- 49: Emitterstruktur
- 50: n⁺-dotiertes Anschlußgebiet
- 51: n⁻-dotierter Driftbereich
- 52: Kathode
- 53: erste Kontakte
- 54: erste Leiterbahn
- 55: zweite Kontakte
- 56: zweite Leiterbahn
- 57: dritte Leiterbahn
- 58: Gateelektrode

## Patentansprüche

1. Schaltungsstruktur mit mindestens einem bipolaren Leistungsbauelement,
- bei der mindestens ein bipolares Leistungsbauelement mit einer Emitterstruktur (12) vorgesehen ist,
- bei der die Emitterstruktur (12) von einem Driftbereich (10) entgegengesetzten Leitfähigkeitstyps umgeben ist, der die Spannungsfestigkeit des Leistungsbauelementes bestimmt,
- bei der die Emitterstruktur (12) mit einem ersten Kontakt (13) und der Driftbereich (10) mit einem zweiten Kontakt (15) versehen ist, wobei der erste Kontakt (13) und der zweite Kontakt (15) zueinander benachbart angeordnet sind,
- bei der der erste Kontakt (13) und der zweite Kontakt (15) mit einer ansteuerbaren Widerstandsschaltung (16) verbunden sind, so daß in Abhängigkeit mindestens eines Steuersignals an der ansteuerbaren Widerstandsschaltung (16) Strom durch das Leistungsbauelement über den ersten Kontakt (13), über den zweiten Kontakt (15) oder über den ersten Kontakt (13) und den zweiten Kontakt (15) zu einem dritten Kontakt (17) der Widerstandsschaltung (16) fließt,
- bei der die Widerstandsschaltung (16) eine Strom-Spannungskennlinie aufweist, deren Verlauf im Bereich des Nulldurchgangs im wesentlichen dem Verlauf der Strom-Spannungskennlinie eines ohmschen Widerstands entspricht.

2. Schaltungsstruktur nach Anspruch 1,
- bei der das Leistungsbauelement und die ansteuerbare Widerstandsschaltung (16) in einem Substrat (1, 2, 3), das Silizium umfaßt, integriert sind,
- bei der in dem Substrat eine dielektrische Isolation (2, 4) vorgesehen ist, durch die das Leistungsbauelement gegen das Substrat und die ansteuerbare Widerstandsschaltung (16) isoliert ist.

3. Schaltungsstruktur nach Anspruch 1 oder 2,
- bei der der Driftbereich (10) einen Anschlußbereich (14) erhöhter Dotierstoffkonzentration gleichen Leitfähigkeitstyps umfaßt, auf dem der zweite Kontakt (15) angeordnet ist.

4. Schaltungsstruktur nach einem der Ansprüche 1 bis 3,
- bei der das Leistungsbauelement einen n⁺-dotierten Sourcebereich (5) umfaßt, der von einem p-dotierten Kanalbereich (6) umgeben ist,
- bei der der Kanalbereich (6) so an den n⁻-dotierten Driftbereich (10) angrenzt, daß ein Strom zwischen dem Sourcebereich (5) und der p⁺-dotierten Emitterstruktur (12) den Driftbereich (10) durchquert,
- bei der eine Kathode (9) vorgesehen ist, die den Sourcebereich (5) mit dem Kanalbereich (6) kurzschließt,
- bei der der Kanalbereich (6) mit einem Gatedielektrikum (7) versehen ist, an dessen Oberfläche eine Gateelektrode (8) angeordnet ist,
- bei der der dritte Kontakt (17) eine Anode des Leistungsbauelementes bildet.

5. Schaltungsstruktur nach einem der Ansprüche 1 bis 4,
- bei der die ansteuerbare Widerstandsschaltung (16) einen Transistor umfaßt, der so zwischen den zweiten Kontakt (15) und den dritten Kontakt (17) geschaltet ist, daß eine Leitfähigkeit zwischen dem zweiten Kontakt (15) und dem dritten Kontakt (17) durch ein Steuersignal an einer Steuerelektrode einstellbar ist,
- bei dem der erste Kontakt (13) direkt mit dem dritten Kontakt (17) verbunden ist.

6. Schaltungsstruktur nach Anspruch 5,
- bei der der Transistor der ansteuerbaren Widerstandsschaltung ein MOS-Transistor ist,
- bei der Source- und Draingebiet des MOS-Transistors jeweils mindestens ein kammförmiges Gebiet umfassen, in dem parallel zueinander angeordnete Stege an ein senkrecht dazu verlaufendes Verbindungsteil angrenzen,
- bei der die kammförmigen Gebiete von Source- und Draingebiet so angeordnet sind, daß die Stege von Source- und Draingebiet jeweils ineinander greifen und daß die Stege des Sourcegebietes und die Stege des Draingebietes jeweils abwechselnd angeordnet sind, so daß der Kanalbereich des MOS-Transistors um die Stege herum gefaltet verläuft,
- bei der das Draingebiet mit dem ersten Kontakt und das Sourcegebiet mit dem zweiten Kontakt verbunden ist.

7. Verfahren zum Betrieb eines bipolaren Leistungsbauelementes mit einer Emitterstruktur, die von einem Driftbereich entgegengesetzten Leitfähigkeitstyps umgeben ist, der die Spannungsfestigkeit des Leistungsbauelementes bestimmt,
- bei dem die Emitterstruktur mit einem ersten Kontakt und der Driftbereich mit einem zweiten Kontakt versehen wird,
- bei dem der erste Kontakt und der zweite Kontakt mit einer ansteuerbaren Widerstandsschaltung verbunden werden, die in Abhängigkeit eines Steuersignals bewirkt, daß Strom durch das Leistungsbauelement über den ersten Kontakt, über den zweiten Kontakt oder über den ersten und den zweiten Kontakt zu einem dritten Kontakt der Widerstandsschaltung fließt,
- bei dem die Widerstandsschaltung eine Kennlinie mit im Bereich des Nulldurchgangs im wesentlichen ohmschen Verlauf aufweist.

8. Verfahren nach Anspruch 7,
- bei dem in der ansteuerbaren Widerstandsschaltung ein Transistor so zwischen den zweiten Kontakt und den dritten Kontakt geschaltet wird, daß seine Leitfähigkeit zwischen dem zweiten Kontakt und dem dritten Kontakt durch ein Steuersignal an einer Steuerelektrode einstellbar ist,
- bei dem der erste Kontakt parallel zu dem Transistor direkt mit dem dritten Kontakt verbunden ist.

9. Verfahren nach Anspruch 7 oder 8,
- bei dem beim Einschalten des Leistungsbauelementes die Widerstandsschaltung so angesteuert wird, daß der Strom durch das Leistungsbauelement über den ersten Kontakt fließt,
- bei dem zum Ausschalten des Leistungsbauelementes die Widerstandsschaltung so angesteuert wird, daß der Strom durch das Leistungsbauelement über den zweiten Kontakt fließt.
